# DEMANDE DE BREVET EUROPEEN

(11) **EP 1 845 621 A1**
(43) Date de publication de la demande: **17.10.2007**
(21) Numéro de dépôt: 07105892.9
(22) Date de dépôt: 10.04.2007
(51) Int. Cl.: H03K 17/16

(54) **Dispositif d'interfaçage de sortie recevant des premier et second signaux d'entrée et délivrant un signal de sortie, et circuit électronique correspondant**

(30) Priorité: 11.04.2006 FR 0603208
(71) Demandeur: ATMEL NANTES SA, 44306 Nantes Cédex 3 (FR)
(72) Inventeur: BENDRAOUI, Abdellatif, 44450, SAINT-JULIEN DE CONCELLES (FR); CHATAL, Joël, 44470, CARQUEFOU (FR); GIBET, Stanislas, 44470, CARQUEFOU (FR)
(74) Mandataire: Guéné, Patrick Lucien Juan Joseph

(57) **Abrégé**

L'invention concerne un dispositif d'interfaçage de sortie (300) recevant des premier (S1) et second (S2) signaux d'entrée et délivrant un signal de sortie (SOUT).

Selon l'invention, un tel dispositif (300) comprend un deuxième étage de commutation à décalage (32) monté en cascade en aval d'un premier étage de commutation. Le deuxième étage de commutation à décalage (32) comprend des moyens de génération de points de commande décalés dans le temps par rapport à des points mémoire.

## Description

### 1. Domaine de l'invention

Le domaine de l'invention est celui des circuits électroniques intégrés et plus particulièrement des circuits (tels que les portes logiques, les mémoires ou encore les microprocesseurs) comprenant des dispositifs d'interfaçage de sortie (ou « output buffers » en anglais) (aussi appelés par la suite périphériques de sortie).

De tels dispositifs d'interfaçage sont bien connus de l'art antérieur. Ils sont généralement placés à la périphérie d'un circuit intégré et sont utilisés pour interfacer des signaux électriques depuis le coeur vers l'extérieur du circuit.

Plus précisément, l'invention concerne l'immunité de tels dispositifs d'interfaçage vis-à-vis du bruit et/ou des perturbations électromagnétiques.

### 2. Solutions et inconvénients de l'art antérieur

De façon générale, tout équipement électronique génère du bruit électromagnétique susceptible de perturber son propre fonctionnement ou celui des appareils qui sont à sa proximité.

La prolifération des équipements à base d'électronique et des systèmes radio a nécessité la définition de réglementations en matière de compatibilité électromagnétique (ou « CEM »).

Par compatibilité électromagnétique, on entend, selon une définition communément admise, l'aptitude d'un matériel ou d'un système à fonctionner dans son environnement électromagnétique de façon satisfaisante et sans produire lui-même de perturbations électromagnétiques intolérables pour tout ce qui se trouve dans cet environnement.

L'environnement électromagnétique est donc devenu un paramètre capital à prendre en compte lors de la conception d'un équipement électronique.

Actuellement, de plus en plus de circuits intégrés sont équipés de dizaines voire de centaines de périphériques de sortie très rapides.

Cependant, ces périphériques génèrent des niveaux de bruit élevés qui peuvent perturber le fonctionnement de systèmes voisins. Ceci est particulièrement gênant, par exemple dans le domaine de l'électronique embarquée.

On rappelle que les pics de courant « di/dt » et/ou de tension « dv/dt », générés à chaque commutation de ces périphériques, sont la source principale des perturbations électromagnétiques conduites et/ou rayonnées.

Sur toutes les figures du présent document, les éléments ou signaux identiques sont désignés par une même référence alphanumérique.

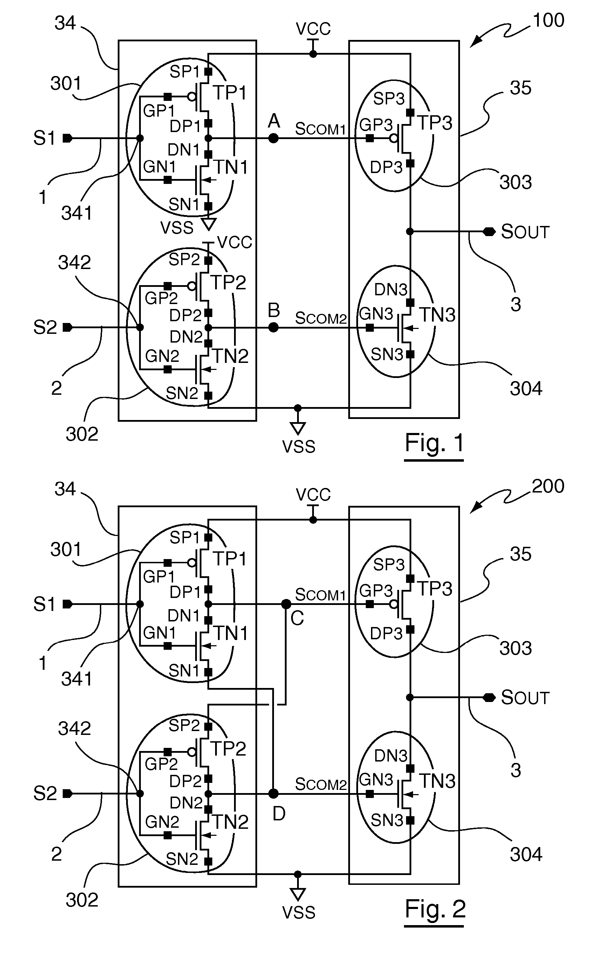

On présente, en relation avec la **figure 1**, le schéma électrique d'un dispositif d'interfaçage de sortie classique, référencé 100 (aussi appelé par la suite premier dispositif d'interfaçage classique ou dispositif d'interfaçage sans anti-court-circuit et sans optimisation CEM).

Par souci de simplification de la description, on se limitera, dans toute la suite de ce document, à décrire le cas particulier des circuits intégrés fonctionnant sous des tensions d'alimentation de 0V et 5V. L'Homme du Métier étendra sans difficulté cet enseignement à tout type de tension destinée à alimenter un circuit électronique intégré.

Le dispositif d'interfaçage de sortie 100 reçoit sur une première entrée 1 un premier signal d'entrée S1 et sur une deuxième entrée 2 un second signal d'entrée S2 et délivre en sortie 3 un signal de sortie SOUT.

Ce dispositif d'interfaçage de sortie 100 comprend un premier étage 34 de commande, comprenant des premiers inverseurs haut 301 et bas 302, et un premier étage 35 de commutation, comprenant des premiers moyens de commutation haut 303 et bas 304.

Plus précisément, le premier inverseur haut 301 reçoit sur une entrée 341 le premier signal d'entrée S1 et délivre à un premier point milieu A un premier signal de commande SCOM1. Cet inverseur haut 301 comprend un transistor TP1, dont la source SP1 est reliée à l'alimentation VCC du circuit (aussi appelée niveau logique haut dans la suite de la description) et dont le drain DP1 est relié au premier point milieu A, et un transistor TN1, dont la source SN1 est reliée au potentiel de référence VSS (aussi appelé niveau logique bas dans la suite de la description) et dont le drain DN1 est relié au drain DP1 du transistor TP1. Les transistors TP1 et TN1 reçoivent sur leur grille GP1 et GN1, le premier signal d'entrée S1.

Ainsi, lorsque le premier signal d'entrée S1 est sensiblement égal au potentiel de référence VSS, soit 0V, le transistor TP1 est rendu passant et le transistor TN1 est rendu bloqué. L'inverseur haut 301 délivre alors au premier point milieu A un premier signal de commande SCOM1 qui est sensiblement égal à l'alimentation VCC, soit 5V.

A l'inverse, lorsque le premier signal d'entrée S1 est sensiblement égal à l'alimentation VCC, soit 5V, le transistor TN1 est rendu passant et le transistor TP1 est rendu bloqué. L'inverseur haut 301 délivre alors au premier point milieu A un premier signal de commande SCOM1 qui est sensiblement égal au potentiel de référence VSS, soit 0V.

Le premier inverseur bas 302 reçoit sur une entrée 342 le second signal d'entrée S2 et délivre à un second point milieu B un deuxième signal de commande SCOM2. Cet inverseur bas 302 comprend un transistor TP2, dont la source SP2 est reliée à l'alimentation VCC et dont le drain DP2 est relié au second point milieu B, et un transistor TN2, dont la source SN2 est reliée au potentiel de référence VSS et dont le drain DN2 est relié au drain DP2 du transistor TP2. Les transistors TP2 et TN2 reçoivent sur leur grille GP2 et GN2, le second signal d'entrée S2.

Ainsi, lorsque le second signal d'entrée S2 est sensiblement égal au potentiel de référence VSS, soit 0V, le transistor TP2 est rendu passant et le transistor TN2 est rendu bloqué. L'inverseur bas 302 délivre alors au second point milieu B un deuxième signal de commande SCOM2 qui est sensiblement égal à l'alimentation VCC, soit 5V.

A l'inverse, lorsque le second signal d'entrée S2 est sensiblement égal à l'alimentation VCC, soit 5V, le transistor TN2 est rendu passant et le transistor TP2 est rendu bloqué. L'inverseur bas 302 délivre alors au second point milieu B un deuxième signal de commande SCOM2 qui est sensiblement égal au potentiel de référence VSS, soit 0V.

Les premiers moyens de commutation haut 303 et bas 304 comprennent respectivement un transistor TP3 et un transistor TN3.

Le transistor TP3, dont la source SP3 est reliée à l'alimentation VCC et dont le drain DP3 est relié à la sortie 3, forme un interrupteur commandé par le premier signal de commande SCOM1 (appliquée sur la grille GP3).

Le transistor TN3, dont la source SN3 est reliée au potentiel de référence VSS et dont le drain DN3 est relié au drain DP3 du transistor TP3, forme un interrupteur commandé par le deuxième signal de commande SCOM2 (appliquée sur la grille GN3).

On décrit ci-après en référence à la figure 1, le fonctionnement du dispositif d'interfaçage de sortie 100 de l'art antérieur, pour quatre combinaisons de signaux d'entrée S1 et S2.

Pour la première combinaison, les premier et second signaux d'entrée S1 et S2 sont sensiblement égaux au potentiel de référence VSS, soit 0V. Les premier et deuxième signaux de commande SCOM1 (délivré au point milieu A) et SCOM2 (délivré au point milieu B) sont alors sensiblement égaux à l'alimentation VCC, soit 5V. Le transistor TP3, dont la grille GP3 reçoit le premier signal de commande SCOM1, est donc placé dans un état bloqué (interrupteur ouvert). En revanche, le transistor TN3, dont la grille GN3 reçoit le deuxième signal de commande SCOM2, est placé dans un état passant (interrupteur fermé), dans lequel il achemine le potentiel de référence VSS vers la sortie 3.

Pour la deuxième combinaison, les premier et second signaux d'entrée S1 et S2 sont sensiblement égaux à l'alimentation VCC, soit 5V. Les premier et deuxième signaux de commande SCOM1 et SCOM2 sont alors sensiblement égaux au potentiel de référence VSS, soit 0V. Le transistor TN3, dont la grille GN3 reçoit le deuxième signal de commande SCOM2, est donc placé dans un état bloqué (interrupteur ouvert). En revanche, le transistor TP3, dont la grille GP3 reçoit le premier signal de commande SCOM1, est placé dans un état passant (interrupteur fermé), dans lequel il achemine l'alimentation VCC vers la sortie 3.

Pour la troisième combinaison, le premier signal d'entrée S1 est sensiblement égal au potentiel de référence VSS, soit 0V, et le second signal d'entrée S2 est sensiblement égal à l'alimentation VCC, soit 5V. Le premier signal de commande SCOM1 est alors sensiblement égal à l'alimentation VCC et le deuxième signal de commande SCOM2 est sensiblement égal au potentiel de référence VSS. Les transistors TP3 et TN3 sont donc tous deux placés dans un état bloqué. Ainsi, pour cette combinaison on obtient un blocage concomitant des moyens de commutation (TP3 et TN3 bloqué). Dans ce cas, on obtient une sortie haute impédance.

Pour la quatrième combinaison, le premier signal d'entrée S1 est sensiblement égal à l'alimentation VCC, soit 5V, et le second signal d'entrée S2 est sensiblement égal au potentiel de référence VSS, soit 0V. Le premier signal de commande SCOM1 est alors sensiblement égal au potentiel de référence VSS et le deuxième signal de commande SCOM2 est sensiblement égal à l'alimentation VCC. Les transistors TP3 et TN3 sont donc tous deux placés dans un état passant.

Ainsi, pour cette combinaison on constate que la technique de l'art antérieur présente un court-circuit entre l'alimentation VCC et le potentiel de référence VSS.

Un autre inconvénient majeur de cette première technique connue réside dans le fait qu'elle présente des problèmes potentiels de fiabilité par électromigration, notamment pour le cas des buffers très rapides.

Par ailleurs, ce premier dispositif d'interfaçage classique présente une variation de courant « di/dt » importante dans les transistors de sortie TP3 et TN3 ; ce qui se traduit par la génération d'un bruit électromagnétique important.

Pour remédier à ce problème de court-circuit, il est traditionnellement envisagé d'introduire des points mémoire dans le dispositif d'interfaçage de sortie 100 précité. Comme illustré par la **figure 2**, dans le dispositif d'interfaçage de sortie classique, référencé 200 (aussi appelé par la suite second dispositif d'interfaçage classique ou dispositif d'interfaçage avec anti-court-circuit et sans optimisation CEM), le point mémoire haut C est obtenu par rebouclage du premier moyen de commutation haut 303 vers le premier inverseur bas 302 (en d'autres termes la grille GP3 du transistor TP3 est reliée à la source SP2 du transistor TP2) et le point mémoire bas D est obtenu par rebouclage du premier moyen de commutation bas 304 vers le premier inverseur haut 301 (en d'autres termes la grille GN3 du transistor TN3 est reliée à la source SN1 du transistor TN1). Ce double rebouclage permet d'imposer une tension stable (ou niveau logique stable) sur les points mémoire haut C et bas D, de façon à supprimer les états logiques indéterminés des premiers moyens de commutation haut 303 et bas 304. Cette solution permet ainsi d'empêcher la mise en conduction des moyens de commutation et éviter le court-circuit, ainsi que le risque de défaillance par électromigration.

En effet, dans le cas de la quatrième combinaison (S1 égal à VCC et S2 égal à VSS), les transistors TN1 et TP2 sont placés dans un état passant et les transistors TP1 et TN2 sont placés dans un état bloqué ; en conséquence, les grilles GP3 et GN3 des transistors TP3 et TN3 sont reliées entre elles et sont flottantes par rapport au potentiel de référence VSS et à l'alimentation VCC. Ainsi, pour cette combinaison le double rebouclage crée un effet capacitive qui maintient les signaux de commande SCOM1 et SCOM2 (appliqués sur les grilles GP3 et GN3, respectivement) à leurs niveaux logiques précédents.

Bien que cette solution de l'art antérieur ait représenté un progrès important dans le mécanisme de suppression de courts-circuits, la seconde technique connue présente néanmoins les désavantages d'avoir un « di/dt » (i.e variation de courant) assez élevé et une perturbation électromagnétique en conséquence. En effet, le double rebouclage du second dispositif d'interfaçage classique 200 permet d'ajuster la pente du signal de sortie en réponse à un front montant ou descendant appliqué en entrée du circuit. En d'autres termes, ce double rebouclage introduit une capacité de charge supplémentaire qui ralentit légèrement la commande des premiers moyens de commutation haut 303 et bas 304 du dispositif d'interfaçage 200. Cependant, ce contrôle ne permet pas de réduire suffisamment les pics de courant « di/dt » en sortie du circuit, de façon à obtenir un bruit généré acceptable.

### 3. Objectifs de l'invention

L'invention a notamment pour objectif de pallier ces inconvénients de l'art antérieur.

Plus précisément, un objectif de l'invention, dans au moins un de ses modes de réalisation, est de fournir une technique permettant de réduire la perturbation électromagnétique d'un dispositif d'interfaçage de sortie.

Un autre objectif de l'invention, dans au moins un de ses modes de réalisation, est de fournir un tel système qui permette de réduire le bruit d'un dispositif d'interfaçage de sortie.

L'invention, dans au moins un de ses modes de réalisation, a encore pour objectif de proposer un tel système qui, à performances identiques en temps de montée et de descente du signal de sortie, permette de réduire les pics de courant « di/dt ».

L'invention, dans au moins un de ses modes de réalisation, a également pour objectif de fournir un tel système qui permette d'éviter des consommations électriques intempestives.

L'invention, dans au moins un de ses modes de réalisation, a encore pour objectif de fournir un tel système qui soit simple à réaliser et pour un faible coût.

### 4. Caractéristiques essentielles de l'invention

Ces objectifs, ainsi que d'autres qui apparaîtront par la suite, sont atteints à l'aide d'un dispositif d'interfaçage de sortie recevant des premier et second signaux d'entrée et délivrant un signal de sortie, ledit signal de sortie étant susceptible de commuter entre un niveau logique haut et un niveau logique bas, ou réciproquement. Le dispositif comprend un premier étage de commutation comprenant :
- des premiers moyens de commutation haut dudit signal de sortie dudit niveau logique bas vers ledit niveau logique haut ;
- des premiers moyens de commutation bas dudit signal de sortie dudit niveau logique haut vers ledit niveau logique bas ;
- des premiers moyens de commande haut et bas agissant sur lesdits premiers moyens de commutation haut et bas, respectivement, lesdits premiers moyens de commande haut et bas recevant en entrée lesdits premier et second signaux d'entrée, respectivement ;
- des premiers points mémoire haut et bas,
   o la sortie des premiers moyens de commande haut et l'entrée desdits premiers moyens de commutation haut étant connectés audit point mémoire haut,
   o la sortie des premiers moyens de commande bas et l'entrée desdits premiers moyens de commutation bas étant connectés audit point mémoire bas ;

Selon l'invention, le dispositif comprend un deuxième étage de commutation à décalage monté en cascade en aval dudit premier étage de commutation et comprenant :
- des deuxièmes moyens de commutation haut dudit signal de sortie ;
- des deuxièmes moyens de commutation bas dudit signal de sortie ;
- des deuxièmes moyens de commande haut et bas agissant sur lesdits deuxièmes moyens de commutation haut et bas, respectivement, via des points de commande haut et bas amonts, respectivement,
   o lesdits deuxièmes moyens de commande haut et bas recevant en entrée lesdits premier et second signaux d'entrée, respectivement,
   o lesdits points de commande haut et bas amonts étant décalés dans le temps par rapport audits points mémoire haut et bas, respectivement.

Ainsi, l'invention repose sur une approche tout à fait nouvelle et inventive de l'immunité d'un dispositif d'interfaçage de sortie vis-à-vis du bruit et/ou des perturbations électromagnétiques. En effet, l'invention propose d'associer un étage de commutation à décalage et un dispositif d'interfaçage équipé d'un anti-court-circuit. Cet étage de commutation à décalage permet ainsi de ralentir la pente maximale (ou « slew rate » en anglais) du signal de sortie en réponse à un échelon en tension appliqué en entrée du dispositif d'interfaçage.

En outre, la perturbation électromagnétique du dispositif d'interfaçage de sortie est avantageusement réduite, du fait que le ralentissement du « slew rate » entraîne la diminution des pics de courant « di/dt » et/ou de tension « dv/dt » dans le dispositif d'interfaçage.

Par ailleurs, il est important de noter qu'on prévoit également une décorrélation des commandes d'activation des moyens de commutation. Cette décorrélation permet ainsi de supprimer les erreurs de commutation, du fait que chaque moyens de commutation reçoit une commande claire d'activation ou de désactivation. En outre, le contrôle indépendant des moyens de commutation haut et bas permet de réduire fortement la consommation électrique du dispositif, en s'assurant que l'un seulement de ces moyens de commutation soit activé à un instant donné.

Selon un aspect avantageux de l'invention, lesdits premiers moyens de génération, compris dans ledit premier étage de commutation, comprennent un double rebouclage desdits premiers moyens de commutation haut vers lesdits premiers moyens de commande bas d'une part et desdits premiers moyens de commutation bas vers lesdits premiers moyens de commande haut d'autre part.

Dans un mode de réalisation préférentiel de l'invention, lesdits deuxièmes moyens de génération, compris dans ledit deuxième étage de commutation à décalage, comprennent :
- des moyens de temporisation haut recevant ledit point mémoire haut et délivrant ledit point de commande haut amont après qu'une première durée de temporisation déterminée soit écoulée depuis la vérification d'au moins un critère de stabilité prédéterminé ;
- des moyens de temporisation bas recevant ledit point mémoire bas et délivrant ledit point de commande bas amont après qu'une deuxième durée de temporisation déterminée soit écoulée depuis la vérification dudit au moins un critère de stabilité prédéterminé.

De façon avantageuse, lesdits moyens de temporisation haut comprennent un premier transistor de type N, et lesdits moyens de temporisation bas comprennent un premier transistor de type P.

De façon préférentielle, lesdits deuxièmes moyens de commande haut comprennent un deuxième transistor de type P monté en grille et drain communs avec ledit premier transistor de type N, de façon à former un premier inverseur, et lesdits deuxièmes moyens de commande bas comprennent un deuxième transistor de type N monté en grille et drain communs avec ledit premier transistor de type P, de façon à former un deuxième inverseur.

Avantageusement, lesdits deuxièmes moyens de commutation haut, compris dans ledit deuxième étage de commutation à décalage, comprennent un troisième transistor de type P comprenant une grille sur laquelle est appliquée ledit point de commande haut amont, et en ce que si ledit point de commande haut amont est inférieure ou égale audit niveau logique bas, ledit troisième transistor de type P autorise la commutation dudit signal de sortie vers le niveau logique haut.

Préférentiellement, lesdits deuxièmes moyens de commutation bas, compris dans ledit deuxième étage de commutation à décalage, comprennent un troisième transistor de type N comprenant une grille sur laquelle est appliquée ledit point de commande bas amont, et en ce que si ledit point de commande bas amont est supérieure ou égale audit niveau logique haut, ledit troisième transistor de type N autorise la commutation dudit signal de sortie vers le niveau logique bas.

Selon un aspect avantageux de l'invention, le dispositif comprend au moins un troisième étage de commutation à décalage placé en aval de et identique audit deuxième étage de commutation à décalage, chaque étage de commutation à décalage placé en aval d'un autre étage de commutation à décalage permettant de générer des points de commande haut et bas avals supplémentaires décalés dans le temps par rapport audits points de commande haut et bas amonts, respectivement, générés dans ledit étage de commutation à décalage placé en amont.

De façon préférentielle, lesdits premiers moyens de commande haut et bas, compris dans ledit premier étage de commutation, comprennent chacun au moins un inverseur.

L'invention concerne également un circuit électronique comprenant un dispositif d'interfaçage de sortie tel que décrit ci-dessus.

### 5. Liste des figures

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :
- la figure 1, déjà commentée en relation avec l'art antérieur, présente un schéma électrique d'un dispositif d'interfaçage classique sans anti-court-circuit et sans optimisation CEM ;
- la figure 2 présente un schéma électrique d'un dispositif d'interfaçage classique avec anti-court-circuit et sans optimisation CEM ;
- la figure 3 présente le schéma électrique d'un dispositif d'interfaçage selon un mode de réalisation préférentiel de l'invention ;
- la figure 4 présente la variation de courant « di/dt » d'un dispositif d'interfaçage de l'invention, pour la montée du signal de sortie de VSS à VCC ; et
- la figure 5 présente la variation de courant « di/dt » d'un dispositif d'interfaçage de l'invention, pour la descente du signal de sortie de VCC à VSS.

### 6. Description d'un mode de réalisation de l'invention

Le principe général de l'invention repose sur l'insertion d'un étage à lignes à retards en sortie d'un dispositif d'interfaçage équipé d'un anti-court-circuit.

Selon l'invention, un étage de commutation à décalage comprend des moyens de génération de points de commande décalés dans le temps, permettant de retarder la commutation du signal de sortie. Cet étage de commutation à décalage permet de ralentir le contrôle du « slew rate », et le cas échéant de diminuer l'amplitude des pics de courant « di/dt » et/ou de tension « dv/dt ».

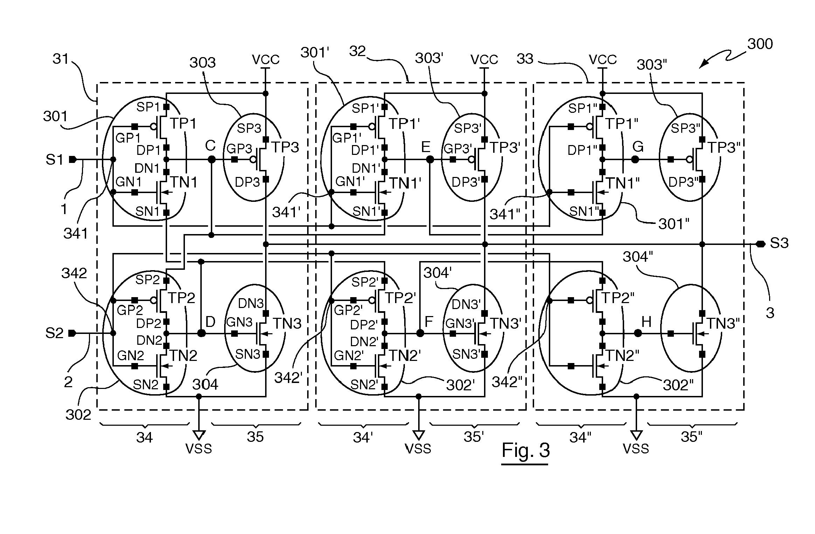

On décrit désormais en relation avec la **figure 3** un dispositif d'interfaçage de sortie 300 selon un mode de réalisation préférentiel de l'invention.

Dans ce mode de réalisation, le dispositif d'interfaçage de sortie 300 selon l'invention comprend :
- un premier étage de commutation 31, jouant le rôle du dispositif d'interfaçage 200 avec anti-court-circuit et sans optimisation CEM décrit en relation avec la figure 2 ; et
- des deuxième 32 et troisième 33 étages de commutation à décalage spécifiques à l'invention.

Par souci de clarté, l'architecture et le fonctionnement détaillés du premier étage de commutation 31 ne sont pas décrits de nouveau ci-après.

Pour mémoire, on rappelle que ce premier étage de commutation 31 comprend :
- des premiers moyens de commutation haut 303 d'un signal de sortie SOUT d'un niveau logique bas (sensiblement égal au potentiel de référence VSS) vers un niveau logique haut (sensiblement égal à l'alimentation VCC) ;
- des premiers moyens de commutation bas 304 du signal de sortie SOUT du niveau logique haut vers le niveau logique bas ;
- des premiers moyens de commande haut 301 et bas 302 agissant sur les premiers moyens de commutation haut 303 et bas 304, respectivement ; et
- des premiers moyens de génération 305 de points mémoire haut C et bas D permettant de faire commuter le signal de sortie SOUT, de sorte que si le point mémoire haut C est sensiblement inférieur au seuil de commutation des premiers moyens de commutation haut 303 (i.e. inférieur à 2,5V) alors le signal de sortie SOUT commute vers le niveau logique haut (soit 5V), en revanche si le point mémoire bas D est sensiblement supérieur au seuil de commutation des premiers moyens de commutation bas 304 (i.e. supérieur à 2,5V) alors le signal de sortie SOUT commute vers le niveau logique bas (soit 0V).

Toujours à titre de rappel, ces premiers moyens de commande haut 301 et bas 302 permettent d'empêcher une activation simultanée des premiers moyens de commutation haut 303 et bas 304 d'une part et d'autoriser un blocage synchronisé des premiers moyens de commutation haut 303 et bas 304 d'autre part, de façon à réduire la consommation électrique du dispositif.

Comme illustré par la figure 3, le deuxième étage de commutation à décalage 32 est monté en cascade en aval du premier étage de commutation 31, et le troisième étage de commutation à décalage 33 est monté en cascade en aval du deuxième étage de commutation à décalage 32.

Comme on le verra par la suite, l'architecture du troisième étage de commutation à décalage 33 est identique à celle du deuxième étage de commutation à décalage 32.

Le dispositif d'interfaçage de sortie 300 selon l'invention reçoit sur une première entrée 1 un premier signal d'entrée S1 et sur une deuxième entrée 2 un second signal d'entrée S2 et délivre en sortie 3 un signal de sortie SOUT.

Le deuxième étage de commutation à décalage 32 comprend un deuxième étage 34' de commande, comprenant des deuxièmes inverseurs haut 301' et bas 302', et un deuxième étage 35' de commutation, comprenant des deuxièmes moyens de commutation haut 303' et bas 304'.

Plus précisément, le deuxième inverseur haut 301' reçoit sur une entrée 341' le premier signal d'entrée S1 et délivre à un premier point de commande haut E un troisième signal de commande SCOM1'. Cet inverseur haut 301' comprend un transistor TP1', dont la source SP1' est reliée à l'alimentation VCC du circuit et dont le drain DP1' est relié au premier point de commande haut E, et un transistor TN1', dont la source SN1' est reliée au point mémoire haut C (généré dans le premier étage de commutation 31) et dont le drain DN1' est relié au drain DP1' du transistor TP1'. Les transistors TP1' et TN1' reçoivent sur leur grille GP1' et GN1', le premier signal d'entrée S1.

Ainsi, lorsque le premier signal d'entrée S1 est sensiblement égal au potentiel de référence VSS, soit 0V, le transistor TP1' est rendu passant et le transistor TN1' est rendu bloqué. Après une certaine latence (qui est fonction du ratio des diverses dimensions des transistors TP1' et TN1'), l'inverseur haut 301' délivre au premier point de commande haut E un troisième signal de commande SCOM1' qui est sensiblement égal à l'alimentation VCC, soit 5V.

A l'inverse, lorsque le premier signal d'entrée S1 est sensiblement égal à l'alimentation VCC, soit 5V, le transistor TN1' est rendu passant et le transistor TP1' est rendu bloqué. Après une certaine latence (qui est fonction du ratio des diverses dimensions des transistors TP1' et TN1'), l'inverseur haut 301' délivre au premier point de commande haut E un troisième signal de commande SCOM1' qui est sensiblement égal au potentiel du point mémoire haut C. En d'autres termes, lorsque le premier signal d'entrée S1 est sensiblement égal à l'alimentation VCC, le deuxième étage de commutation à décalage 32 génère un premier point de commande haut E décalé dans le temps par rapport au point mémoire haut C.

Le deuxième inverseur bas 302' reçoit sur une entrée 342' le second signal d'entrée S2 et délivre à un premier point de commande bas F un quatrième signal de commande SCOM2'. Cet inverseur bas 302' comprend un transistor TP2', dont la source SP2' est reliée au point mémoire bas D (généré dans le premier étage de commutation 31) et dont le drain DP2' est relié au premier point de commande bas F, et un transistor TN2', dont la source SN2' est reliée au potentiel de référence VSS et dont le drain DN2' est relié au drain DP2' du transistor TP2'. Les transistors TP2' et TN2' reçoivent sur leur grille GP2' et GN2', le second signal d'entrée S2.

Ainsi, lorsque le second signal d'entrée S2 est sensiblement égal au potentiel de référence VSS, soit 0V, le transistor TP2' est rendu passant et le transistor TN2' est rendu bloqué. Après une certaine latence (qui est fonction du ratio des diverses dimensions des transistors TP2' et TN2'), l'inverseur bas 302' délivre au premier point de commande bas F un quatrième signal de commande SCOM2' qui est sensiblement égal au potentiel du point mémoire bas D. En d'autres termes, lorsque le second signal d'entrée S2 est sensiblement égal au potentiel de référence VSS, le deuxième étage de commutation à décalage 32 génère un premier point de commande bas F décalé dans le temps par rapport au point mémoire bas D.

A l'inverse, lorsque le second signal d'entrée S2 est sensiblement égal à l'alimentation VCC, soit 5V, le transistor TN2' est rendu passant et le transistor TP2' est rendu bloqué. Après une certaine latence (qui est fonction du ratio des diverses dimensions des transistors TP2' et TN2'), l'inverseur bas 302' délivre au premier point de commande bas F un quatrième signal de commande SCOM2' qui est sensiblement égal au potentiel de référence VSS, soit 0V.

Les deuxièmes moyens de commutation haut 303' et bas 304' comprennent respectivement un transistor TP3' et un transistor TN3'.

Le transistor TP3', dont la source SP3' est reliée à l'alimentation VCC et dont le drain DP3' est relié à la sortie 3, forme un interrupteur commandé par le troisième signal de commande SCOM1' (appliquée sur la grille GP3').

Le transistor TN3', dont la source SN3' est reliée au potentiel de référence VSS et dont le drain DN3' est relié au drain DP3' du transistor TP3', forme un interrupteur commandé par le quatrième signal de commande SCOM2' (appliquée sur la grille GN3').

Comme déjà indiqué, le troisième étage de commutation à décalage 33 est placé en aval de et identique au deuxième étage de commutation à décalage 32.

De façon plus détaillée, le troisième étage de commutation à décalage 33 comprend un troisième étage 34" de commande, comprenant des troisièmes inverseurs haut 301" et bas 302", et un troisième étage 35" de commutation, comprenant des troisièmes moyens de commutation haut 303" et bas 304".

Plus précisément, le troisième inverseur haut 301" reçoit sur une entrée 341" le premier signal d'entrée S1 et délivre à un deuxième point de commande haut G un cinquième signal de commande SCOM1". Cet inverseur haut 301" comprend un transistor TP1", dont la source SP1" est reliée à l'alimentation VCC du circuit et dont le drain DP1" est relié au deuxième point de commande haut G, et un transistor TN1", dont la source SN1" est reliée au premier point de commande haut E (généré dans le deuxième étage de commutation 32) et dont le drain DN1" est relié au drain DP1" du transistor TP1". Les transistors TP1" et TN1" reçoivent sur leur grille GP1" et GN1", le premier signal d'entrée S1.

Ainsi, lorsque le premier signal d'entrée S1 est sensiblement égal au potentiel de référence VSS, soit 0V, le transistor TP1" est rendu passant et le transistor TN1" est rendu bloqué. Après une certaine latence (qui est fonction du ratio des diverses dimensions des transistors TP1" et TN1"), l'inverseur haut 301" délivre au deuxième point de commande haut G un cinquième signal de commande SCOM1" qui est sensiblement égal à l'alimentation VCC, soit 5V.

A l'inverse, lorsque le premier signal d'entrée S1 est sensiblement égal à l'alimentation VCC, soit 5V, le transistor TN1" est rendu passant et le transistor TP1" est rendu bloqué. Après une certaine latence (qui est fonction du ratio des diverses dimensions des transistors TP1" et TN1"), l'inverseur haut 301" délivre au deuxième point de commande haut G un cinquième signal de commande SCOM1" qui est sensiblement égal au potentiel du premier point de commande haut E. En d'autres termes, lorsque le premier signal d'entrée S1 est sensiblement égal à l'alimentation VCC, le troisième étage de commutation à décalage 33 génère un deuxième point de commande haut G décalé dans le temps par rapport au premier point de commande haut E.

Le troisième inverseur bas 302" reçoit sur une entrée 342" le second signal d'entrée S2 et délivre à un deuxième point de commande bas H un sixième signal de commande SCOM2". Cet inverseur bas 302" comprend un transistor TP2", dont la source SP2" est reliée au premier point de commande bas F (généré dans le deuxième étage de commutation 32) et dont le drain DP2" est relié au deuxième point de commande bas H, et un transistor TN2", dont la source SN2" est reliée au potentiel de référence VSS et dont le drain DN2" est relié au drain DP2" du transistor TP2". Les transistors TP2" et TN2" reçoivent sur leur grille GP2" et GN2", le second signal d'entrée S2.

Ainsi, lorsque le second signal d'entrée S2 est sensiblement égal au potentiel de référence VSS, soit 0V, le transistor TP2" est rendu passant et le transistor TN2" est rendu bloqué. Après une certaine latence (qui est fonction du ratio des diverses dimensions des transistors TP2" et TN2"), l'inverseur bas 302" délivre au deuxième point de commande bas H un sixième signal de commande SCOM2" qui est sensiblement égal au potentiel du premier point de commande bas F. En d'autres termes, lorsque le second signal d'entrée S2 est sensiblement égal au potentiel de référence VSS, le troisième étage de commutation à décalage 33 génère un deuxième point de commande bas H décalé dans le temps par rapport au premier point de commande bas F.

A l'inverse, lorsque le second signal d'entrée S2 est sensiblement égal à l'alimentation VCC, soit 5V, le transistor TN2" est rendu passant et le transistor TP2" est rendu bloqué. Après une certaine latence (qui est fonction du ratio des diverses dimensions des transistors TP2" et TN2"), l'inverseur bas 302" délivre au deuxième point de commande bas H un sixième signal de commande SCOM2" qui est sensiblement égal au potentiel de référence VSS, soit 0V.

Les troisièmes moyens de commutation haut 303" et bas 304" comprennent respectivement un transistor TP3" et un transistor TN3".

Le transistor TP3", dont la source SP3" est reliée à l'alimentation VCC et dont le drain DP3" est relié à la sortie 3, forme un interrupteur commandé par le cinquième signal de commande SCOM1" (appliquée sur la grille GP3").

Le transistor TN3", dont la source SN3" est reliée au potentiel de référence VSS et dont le drain DN3" est relié au drain DP3" du transistor TP3", forme un interrupteur commandé par le sixième signal de commande SCOM2" (appliquée sur la grille GN3").

Comme déjà indiqué, le premier étage de commutation 31 comprend un double rebouclage permettant de générer une tension stable sur les grilles des transistors de commutation TP3 et TN3 (lorsque le premier signal d'entrée S1 est égal à l'alimentation VCC et le second signal d'entrée S2 est égal au potentiel de référence VSS), de façon à empêcher un court-circuit, c'est-à-dire une activation simultanée des transistors de commutation TP3 et TN3.

Par souci de simplification de la description, on se limitera, dans toute la suite de ce document, à décrire le cas particulier d'un double rebouclage générant une tension stable d'environ 0V.

On décrit ci-après en référence à la figure 3, le fonctionnement du dispositif d'interfaçage de sortie 300 selon l'invention, pour quatre combinaisons de signaux d'entrée S1 et S2.

Pour la première combinaison, les premier et second signaux d'entrée S1 et S2 sont sensiblement égaux au potentiel de référence VSS, soit 0V.

Dans un premier temps, les premier et deuxième signaux de commande SCOM1 (délivré au point mémoire haut C) et SCOM2 (délivré au point mémoire bas D) prennent la valeur de l'alimentation VCC, soit 5V.

Après une première latence (correspondant à un retard introduit par les deuxièmes inverseurs haut 301' et bas 302' du deuxième étage de commutation à décalage 32), les troisième et quatrième signaux de commande SCOM1' (délivré au premier point de commande haut E) et SCOM2' (délivré au premier point de commande bas F) prennent la valeur de l'alimentation VCC, soit 5V.

Après une deuxième latence (correspondant à un retard introduit par les troisièmes inverseurs haut 301" et bas 302" du troisième étage de commutation à décalage 33), les cinquième et sixième signaux de commande SCOM1" (délivré au deuxième point de commande haut G) et SCOM2" (délivré au deuxième point de commande bas H) prennent la valeur de l'alimentation VCC, soit 5V.

Ainsi, les transistors de commutation TN3 du premier étage de commutation 31, TN3' du deuxième étage de commutation à décalage 32 et TN3" du troisième étage de commutation à décalage 33 sont placés l'un après l'autre dans un état passant, de façon à obtenir une commutation retardée du signal de sortie SOUT (délivré en sortie 3) vers le potentiel de référence VSS, soit 0V.

Comme on le verra par la suite, chaque étage de commutation contribue à la réduction des pics de courant « di/dt » dans le dispositif.

Pour la deuxième combinaison, les premier et second signaux d'entrée S1 et S2 sont sensiblement égaux à l'alimentation VCC, soit 5V.

Dans un premier temps, les premier et deuxième signaux de commande SCOM1 (délivré au point mémoire haut C) et SCOM2 (délivré au point mémoire bas D) prennent la valeur du potentiel de référence VSS, soit 0V.

Après une première latence (correspondant à un retard introduit par les deuxièmes inverseurs haut 301' et bas 302' du deuxième étage de commutation à décalage 32), les troisième et quatrième signaux de commande SCOM1' (délivré au premier point de commande haut E) et SCOM2' (délivré au premier point de commande bas F) prennent la valeur du potentiel de référence VSS, soit 0V.

Après une deuxième latence (correspondant à un retard introduit par les troisièmes inverseurs haut 301" et bas 302" du troisième étage de commutation à décalage 33), les cinquième et sixième signaux de commande SCOM1" (délivré au deuxième point de commande haut G) et SCOM2" (délivré au deuxième point de commande bas H) prennent la valeur du potentiel de référence VSS, soit 0V.

Ainsi, les transistors de commutation TP3 du premier étage de commutation 31, TP3' du deuxième étage de commutation à décalage 32 et TP3" du troisième étage de commutation à décalage 33 sont placés l'un après l'autre dans un état passant, de façon à obtenir une commutation retardée du signal de sortie SOUT (délivré en sortie 3) vers l'alimentation VCC, soit 5V.

Pour la troisième combinaison, le premier signal d'entrée S1 est sensiblement égal au potentiel de référence VSS, soit 0V, et le second signal d'entrée S2 est sensiblement égal à l'alimentation VCC, soit 5V.

Dans un premier temps, le premier signal de commande SCOM1 (délivré au point mémoire haut C) prend la valeur de l'alimentation VCC et le deuxième signal de commande SCOM2 (délivré au point mémoire bas D) prend la valeur du potentiel de référence VSS.

Après une première latence (correspondant à un retard introduit par les deuxièmes inverseurs haut 301' et bas 302' du deuxième étage de commutation à décalage 32), le troisième signal de commande SCOM1' (délivré au premier point de commande haut E) prend la valeur de l'alimentation VCC et le quatrième signal de commande SCOM2' (délivré au premier point de commande bas F) prend la valeur du potentiel de référence VSS.

Après une deuxième latence (correspondant à un retard introduit par les troisièmes inverseurs haut 301" et bas 302" du troisième étage de commutation à décalage 33), le cinquième signal de commande SCOM1" (délivré au deuxième point de commande haut G) prend la valeur de l'alimentation VCC et le sixième signal de commande SCOM2" (délivré au deuxième point de commande bas H) prend la valeur du potentiel de référence VSS.

Ainsi, pour cette combinaison on obtient un blocage concomitant des moyens de commutation (les transistors de commutation de chaque étage de commutation sont bloqués). Dans ce cas, on obtient une sortie haute impédance.

Pour la quatrième combinaison, le premier signal d'entrée S1 est sensiblement égal à l'alimentation VCC, soit 5V, et le second signal d'entrée S2 est sensiblement égal au potentiel de référence VSS, soit 0V.

Pour cette combinaison, le double rebouclage impose une tension stable de 0V sur les points mémoire haut C et bas D.

Du fait que les transistors de commande TN1 et TP2 du premier étage de commutation 31, TN1' et TP2' du deuxième étage de commutation à décalage 32 et TN1" et TP2" du troisième étage de commutation à décalage 33 sont dans un état passant, cette tension stable se propage progressivement dans chaque étage de commutation, de sorte que les signaux de commande de chaque étage prennent la valeur de la tension stable, soit 0V.

Ainsi, les transistors de commutation TP3 du premier étage de commutation 31, TP3' du deuxième étage de commutation à décalage 32 et TP3" du troisième étage de commutation à décalage 33 sont placés l'un après l'autre dans un état passant, de façon à obtenir une commutation retardée du signal de sortie SOUT (délivré en sortie 3) vers l'alimentation VCC, soit 5V.

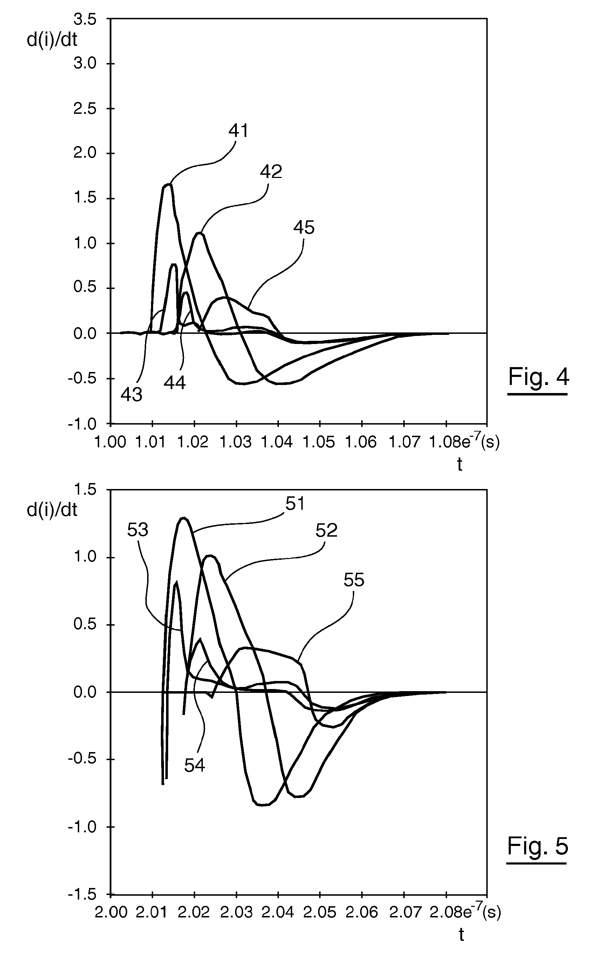

On présente en relation avec la **figure 4**, les performances (obtenues par simulation) du dispositif d'interfaçage de sortie 300 de l'invention, pour une combinaison de signaux d'entrée S1 et S2 (S1 et S2 sont égaux à VCC) correspondant à la montée du signal de sortie SOUT de VSS à VCC.

Plus précisément, la figure 4 présente cinq courbes référencées 41 à 45 illustrant la variation de courant « di/dt » en fonction du temps t (en s) pour le premier dispositif d'interfaçage classique 100, le second dispositif d'interfaçage classique 200 et le dispositif d'interfaçage de l'invention 300.

Ainsi, la courbe référencée 41 correspond à la variation de courant « di/dt » dans le premier dispositif d'interfaçage classique 100, la courbe référencée 42 correspond à la variation de courant « di/dt » dans le second dispositif d'interfaçage classique 200 et les courbes référencées 43, 44 et 45 correspondent respectivement à la variation de courant « di/dt » aux premier 31, deuxième 32 et troisième 33 étages de commutation du dispositif d'interfaçage de l'invention 300.

Comme l'illustre la figure 4, le dispositif d'interfaçage de l'invention présente des performances satisfaisantes puisqu'il apporte une réduction des pics de courant « di/dt » de l'ordre de 60% par rapport au dispositif d'interfaçage classique 100.

On présente en relation avec la **figure 5**, les performances (obtenues par simulation) du dispositif d'interfaçage de sortie 300 de l'invention, pour une combinaison de signaux d'entrée S1 et S2 (S1 et S2 sont égaux à VSS) correspondant à la descente du signal de sortie SOUT de VCC à VSS.

Plus précisément, la figure 5 présente cinq courbes référencées 51 à 55 illustrant la variation de courant « di/dt » en fonction du temps t (en s) pour le premier dispositif d'interfaçage classique 100, le second dispositif d'interfaçage classique 200 et le dispositif d'interfaçage de l'invention 300.

Ainsi, la courbe référencée 51 correspond à la variation de courant « di/dt » dans le premier dispositif d'interfaçage classique 100, la courbe référencée 52 correspond à la variation de courant « di/dt » dans le second dispositif d'interfaçage classique 200 et les courbes référencées 53, 54 et 55 correspondent respectivement à la variation de courant « di/dt » aux premier 31, deuxième 32 et troisième 33 étages de commutation du dispositif d'interfaçage de l'invention 300.

Comme l'illustre la figure 5, le dispositif d'interfaçage de l'invention présente des performances satisfaisantes puisqu'il apporte une réduction des pics de courant « di/dt » de l'ordre de 40% par rapport au dispositif d'interfaçage classique 100.

## Revendications

1. Dispositif d'interfaçage de sortie (300) recevant des premier (S1) et second (S2) signaux d'entrée et délivrant un signal de sortie (SOUT), ledit signal de sortie (SOUT) étant susceptible de commuter entre un niveau logique haut (VCC) et un niveau logique bas (VSS), ou réciproquement, ledit dispositif comprenant un premier étage de commutation (31) comprenant :
- des premiers moyens de commutation haut (303) dudit signal de sortie (SOUT) dudit niveau logique bas vers ledit niveau logique haut ;
- des premiers moyens de commutation bas (304) dudit signal de sortie (SOUT) dudit niveau logique haut vers ledit niveau logique bas ;
- des premiers moyens de commande haut (301) et bas (302) agissant sur lesdits premiers moyens de commutation haut (303) et bas (304), respectivement, lesdits premiers moyens de commande haut (301) et bas (302) recevant en entrée lesdits premier (S1) et second (S2) signaux d'entrée, respectivement ;
- des premiers points mémoire haut (C) et bas (D),
o la sortie des premiers moyens de commande haut (301) et l'entrée desdits premiers moyens de commutation haut (303) étant connectés audit point mémoire haut (C),
o la sortie des premiers moyens de commande bas (302) et l'entrée desdits premiers moyens de commutation bas (304) étant connectés audit point mémoire bas (D) ;
**caractérisé en ce que** ledit dispositif comprend un deuxième étage de commutation à décalage (32) monté en cascade en aval dudit premier étage de commutation (31) et comprenant :
- des deuxièmes moyens de commutation haut (303') dudit signal de sortie (SOUT) ;
- des deuxièmes moyens de commutation bas (304') dudit signal de sortie (SOUT) ;
- des deuxièmes moyens de commande haut (301') et bas (302') agissant sur lesdits deuxièmes moyens de commutation haut (303') et bas (304'), respectivement, via des points de commande haut (E) et bas (F) amonts, respectivement,
o lesdits deuxièmes moyens de commande haut (301') et bas (302') recevant en entrée lesdits premier (S1) et second (S2) signaux d'entrée, respectivement,
o lesdits points de commande haut (E) et bas (F) amonts étant décalés dans le temps par rapport audits points mémoire haut (C) et bas (D), respectivement.

2. Dispositif d'interfaçage selon la revendication 1, **caractérisé en ce que** lesdits premiers moyens de génération, compris dans ledit premier étage de commutation (31), comprennent un double rebouclage desdits premiers moyens de commutation haut (303) vers lesdits premiers moyens de commande bas (302) d'une part et desdits premiers moyens de commutation bas (304) vers lesdits premiers moyens de commande haut (301) d'autre part.

3. Dispositif d'interfaçage selon l'une quelconque des revendications 1 et 2, **caractérisé en ce que** lesdits deuxièmes moyens de génération, compris dans ledit deuxième étage de commutation à décalage (32), comprennent :
- des moyens de temporisation haut recevant ledit point mémoire haut (C) et délivrant ledit point de commande haut (E) amont après qu'une première durée de temporisation déterminée soit écoulée depuis la vérification d'au moins un critère de stabilité prédéterminé ;
- des moyens de temporisation bas recevant ledit point mémoire bas (D) et délivrant ledit point de commande bas (F) amont après qu'une deuxième durée de temporisation déterminée soit écoulée depuis la vérification dudit au moins un critère de stabilité prédéterminé.

4. Dispositif d'interfaçage selon la revendication 3, **caractérisé en ce que** lesdits moyens de temporisation haut comprennent un premier transistor de type N (TN1'), et lesdits moyens de temporisation bas comprennent un premier transistor de type P (TP2').

5. Dispositif d'interfaçage selon la revendication 4, **caractérisé en ce que** lesdits deuxièmes moyens de commande haut (301') comprennent un deuxième transistor de type P (TP1') monté en grille et drain communs avec ledit premier transistor de type N (TN1'), de façon à former un premier inverseur, et lesdits deuxièmes moyens de commande bas (302') comprennent un deuxième transistor de type N (TN2') monté en grille et drain communs avec ledit premier transistor de type P (TP2'), de façon à former un deuxième inverseur.

6. Dispositif d'interfaçage selon l'une quelconque des revendications 1 à 5, **caractérisé en ce que** lesdits deuxièmes moyens de commutation haut (303'), compris dans ledit deuxième étage de commutation à décalage (32), comprennent un troisième transistor de type P (TP3') comprenant une grille sur laquelle est appliquée ledit point de commande haut (E) amont, et **en ce que** si ledit point de commande haut (E) amont est inférieure ou égale audit niveau logique bas (VSS), ledit troisième transistor de type P (TP3') autorise la commutation dudit signal de sortie (SOUT) vers le niveau logique haut (VCC).

7. Dispositif d'interfaçage selon l'une quelconque des revendications 1 à 6, **caractérisé en ce que** lesdits deuxièmes moyens de commutation bas (304'), compris dans ledit deuxième étage de commutation à décalage (32), comprennent un troisième transistor de type N (TN3') comprenant une grille sur laquelle est appliquée ledit point de commande bas (F) amont, et **en ce que** si ledit point de commande bas (F) amont est supérieure ou égale audit niveau logique haut (VCC), ledit troisième transistor de type N (TN3') autorise la commutation dudit signal de sortie (SOUT) vers le niveau logique bas (VSS).

8. Dispositif d'interfaçage selon l'une quelconque des revendications 1 à 7, **caractérisé en ce qu'**il comprend au moins un troisième étage de commutation à décalage (33) placé en aval de et identique audit deuxième étage de commutation à décalage (32), chaque étage de commutation à décalage placé en aval d'un autre étage de commutation à décalage permettant de générer des points de commande haut (G) et bas (H) avals supplémentaires décalés dans le temps par rapport audits points de commande haut (E) et bas (F) amonts, respectivement, générés dans ledit étage de commutation à décalage placé en amont.

9. Dispositif d'interfaçage selon l'une quelconque des revendications 1 à 8, **caractérisé en ce que** lesdits premiers moyens de commande haut (301) et bas (302), compris dans ledit premier étage de commutation (31), comprennent chacun au moins un inverseur.

10. Circuit électronique **caractérisé en ce qu'**il comprend un dispositif d'interfaçage de sortie (300) selon l'une quelconque des revendications 1 à 9.
